# EUROPÄISCHE PATENTSCHRIFT

(11) **EP 0 960 038 B1**
(45) Veröffentlichungstag und Bekanntmachung des Hinweises auf die Patenterteilung: **19.09.2001**
(21) Anmeldenummer: 98912308.8
(22) Anmeldetag: 13.02.1998
(51) Int. Cl.: B60R 16/02

(54) **VERFAHREN ZUR HERSTELLUNG EINES KABELBAUMES**
MANUFACTURE OF A WIRING LOOM
MODE DE FABRICATION D'UN HARNAIS DE CABLES

(30) Priorität: 13.02.1997 DE 19705439
(43) Veröffentlichungstag der Anmeldung: 01.12.1999
(73) Patentinhaber: LEONI Bordnetz-Systeme GmbH & Co KG, 90402 Nürnberg (DE)
(72) Erfinder: REICHINGER, Gerhard, D-91126 Rednitzhembach (DE)
(74) Vertreter: Tergau & Pohl Patentanwälte
(86) Internationale Anmeldenummer: EP9800831
(87) Internationale Veröffentlichungsnummer: WO9835856

(56) Entgegenhaltungen:
- EP-A- 0 590 694
- DE-A- 2 333 170
- FR-A- 2 371 858
- FR-A- 2 569 146
- US-A- 5 309 634

## Beschreibung

Bei einem üblichen Verfahren zur Herstellung eines Kabelbaumes insbesondere für Kraftfahrzeuge werden sogenannte Verlegebretter verwendet. Auf einem Verlegebrett ist der Verlauf des späteren Kabelbaums vorgegeben. Die Einzeladern werde sukzessive an dem Verlegebrett mit Hilfe von mechanischen Fixierelementen befestigt. Ein Kabelbaum wird üblicherweise mit Verbindungselementen, etwa Steckern oder Buchsen, bestückt. Die Einzeladern werden meist mit Hilfe von Klebebändern umwickelt, um den Zusammenhalt der Einzeladern zu gewährleisten. Vielfach reicht eine solche Fixierung bzw. Umantelung nicht aus. Der Kabelbaum wird in diesen Fällen in eine Spritzgußform eingelegt und mit einem Kunststoffmaterial umgossen bzw. umschäumt.

Es liegt auf der Hand, daß ein solches Herstellungsverfahren sehr arbeits- und kostenaufwendig ist. Es wurden deshalb verschiedene alternative Herstellungsverfahren vorgeschlagen, die insbesondere bei kleineren Kabelbäumen oder Flachkabelbäumen Anwendung finden. Beispielsweise ist in DE 27 58 491 ein Verfahren zur Herstellung eines flachen Kabelbaums beschrieben, bei dem aus einem granulierten, thermoplastischen Schmelzklebe-Kunststoff eine Folie hergestellt wird. In einer Einlegevorrichtung werden die Einzeladern eines Flachkabelbaums parallel zueinander positioniert und die Schmelzkleberfolie auf die Leitungen gelegt. Durch leichten Druck in einer Heizvorrichtung wird der Schmelzkleber auf die Leitungen aufgeschmolzen. In DE 23 33 170 A1 sowie in DE 27 58 472 ist jeweils ein Verfahren zur Herstellung eines flachen Kabelbaums beschrieben, bei dem die Einzeladern zwischen zwei Folienlagen angeordnet werden. Gemäß DE 27 58 472 sind die Einzeladem bereits mit einer Isolation versehenen und die Folienlagen werden mit Hilfe eines Hochfrequenz-Schweißverfahrens miteinander verbunden. Aus DE 27 51 771 A1 ist ein Verfahren zur Herstellung eines Kabelbaumes gemäß dem Oberbegriff des Anspruchs 1 zu entnehmen, wobei Einzeladern auf einer Montageunterlage mittels eines Klebers haftend angeordnet und anschließend die Ein-zeladern in ihrer Lage beispielsweise mit einem härtbaren Kunststoff fixiert werden. Ein Verfahren, bei dem der Kabelbaum bzw. eine Verdrahtungsanordnung in einen Türrahmen integriert wird, ist in DE 37 40 593 C2 beschrieben. Der Türrahmen besteht dabei aus einem Kunstharz. Die die Verdrahtungsanordnung bildenden Leitungen sind entweder in Nuten des Kunstharz-Türrahmens eingelassen, in das Kunstharzmaterial durch Ultraschallschweißung versenkt oder auf die Oberfläche des Türrahmens geätzt. Die Aufbringung eines Kabelbaums an einem Fahrzeugbauteil ist auch aus US 5,309,634 bekannt.

Aufgabe der Erfindung ist es, ein alternatives Verfahren zur Herstellung eines Kabelbaumes vorzuschlagen, mit dem auch Kabelbäume komplexerer Natur herstellbar sind und das nicht nur für eine separate Kabelbaumherstellung, sondern auch für einen Aufbau eines Kabelbaums direkt an einem Fahrzeugbauteil geeignet ist. Weiterhin soll das Verfahren so gestaltet sein, daß es nahezu vollständig automatisierbar ist.

Diese Aufgabe wird durch ein Verfahren mit den Merkmalen des Anspruches 1 gelöst. Danach wird auf die Montageseite einer Montageunterlage eine im wesentlichen streifenförmige, dem Verlauf des späteren Verlauf des Kabelbaums zumindest abschnittsweise folgende Basisschicht aufgebracht. Die Basisschicht haftet zumindest vorübergehend an der Montageunterlage. Die Basisschicht wird vorzugsweise mit Hilfe eines Roboters automatisch verlegt. Gleiches trifft für die Verlegung der Adern auf der Basisschicht zu. Hier ist es denkbar, daß ein Verlegekopf die einzelnen Adern aus einem Ader-Magazin entnimmt und einzeln oder gleich zu mehreren im wesentlichen parallel auf der Basisschicht verlegt. Wenn hier und im folgenden von Adern gesprochen wird, so sind darunter ganz allgemein jede Art von elektrischen Leitern zu verstehen, etwa Flachbänder, metallisch leitende oder metallisch beschichtete Kunststoffe, Lichtwellenleiter, metallische Folienleiter oder dergleichen zu verstehen. Auf eine beispielsweise auf die geschilderte Art hergestellte Aderschicht wird dann als dritter Verfahrensschritt eine Deckschicht aus einem flüssigen oder geschmolzenen Kunststoffmaterial aufgesprüht, aufextrudiert, aufgegossen oder aufgestrichen oder es wird ein granuliertes oder pulverförmiges Kunststoffmaterial aufgebracht und anschließend nach Art eines Sinterprozesses mit Wärme, Ultraschall oder dergleichen behandelt, wobei das Kunststoffmaterial die Adern einhüllt, an der Basisschicht haftet und aushärtet bzw. allgemein in eine festere Konsistenz übergeht. Wenn hier von einem flüssigen Kunststoffmaterial gesprochen wird, so sollen darunter auch zwei Komponenten-Kunststoffe verstanden werden. Ein solcher Kunststoff ist beispielsweise Polyurethan. Die Ausgangsmischung eines solchen Kunststoffes enthält zwei Komponenten (Olefin- und Cyanid-Komponente), die im Augenblick ihres Zusammenmischens miteinander reagieren. Wenn man im einfachsten Fall davon ausgeht, daß die Basisschicht und die Deckschicht aus demselben Material besteht, so wäre zur Herstellung eines ein- oder mehrschichtigen Kabelbaumes lediglich ein von einem Roboter geführter Auftragekopf für die Kunststoffmasse und eine Verlegevorrichtung für die Einzeladem notwendig.

Die Basisschicht wird dabei erzeugt, indem eine zunächst flüssige Kunststoffmasse auf die Montageunterlage aufgesprüht aufgegossen aufextrudiert oder auch aufgestri chen wird, wobei die Kunststoffmasse danach in eine festere Konsistenz übergeht bzw. zumindest in gewissem Maße aushärtet Weiterhin kann die Basisschicht - wie oben bei der Deckschicht beschrieben - erzeugt werden, indem ein granuliertes oder pulverförmiges Kunststoffmaterial aufgebracht und anschließend durch Anwendung von Wärme, Ultraschall oder dergleichen für ein Zusammenbacken der Kunststoffpartikel nach Art einer Sinterung gesorgt wird. Für die Basisschicht kann - wie bereits oben erwähnt - das selbe Material verwendet werden wie für eine Deckschicht, so daß das weiter oben zum Material der Deckschicht gesagte hier analog gilt. Es kann z. B. ein Kunststoff verwendet werden, der sehr schnell aushärtet, der also kurz nach dem Auftragen seine endgültige Konsistenz erreicht. Ein solcher Kunststoff ist beispielsweise ein Polyurea-Sprühelastometer. Es handelt sich dabei um eine relativ leichtflüssige Ausgangsmischung zwei miteinander reagierender Komponenten (Isocyanat und sekundäres oder tertiäres Amin), die in einem Mischkopf kurz vor dem Auftrag auf die Montageunterlage miteinander in Kontakt gebracht bzw. miteinander vermischt werden. Zur Herstellung der Basisschicht kann auch eine Kunststoffschmelze oder die Ausgangsmischung eines Zweikomponentenkunststoffes verwendet werden. Ein solcher Kunststoff ist beispielsweise Polyurethan. Die Basisschicht soll in der Regel eine vorgegebene Breite aufweisen. Im Falle von weniger schnellhärtenden Kunststoffen kann das Auseinanderfließen der Kunststoffschmelze bzw. des flüssigen Ausgangsgemisches durch Zuhilfnahme eines entsprechenden Werkzeuges verhindert werden. Die Basisschicht wird dabei thixotrop eingestellt. Ein Auseinanderfließen eines aufgetragenen Kunststoffbandes ist damit im wesentlichen verhindert.

Nach Anspruch 2 bildet die Montageunterlage selbst das Fahrzeugbauteil, beispielsweise eine Fahrzeugtüre. In einem solchen Falles ist die Basisschicht bleibend an dem Fahrzeugbauteil fixiert. Diese Fixierung kann allein über die adhäsiven Eigenschaften der miteinander zusammenwirkenden Materialen erreicht werden. Zur Unterstützung der adhäsiven bzw. stoffschlüssigen Haftung kann das Fahrzeugbauteil Hinterschneidungen, etwa Verschränkungen oder Vertiefungen aufweisen, die beim Auftragen der Basisschicht mit Kunststoffmaterial gefüllt werden und so eine zusätzliche mechanische bzw. formschlüssige Verbindung zwischen der Basisschicht und dem Fahrzeugbauteil gewährleisten. Viele Automobilhersteller gehen heute dazu über, von ihren Zulieferern eine zunehmende Fertigungstiefe zu verlangen. Im Zuge dieser Anforderungen werden von den Zulieferern komplette Baugruppen gefertigt, die im Herstellerwerk im wesentlichen nur noch an der Fahrzeugkarosserie montiert werden müssen. Ein solches Bauteil ist beispielsweise eine Fahrzeugtüre oder eine Heckklappe. Mit dem Verfahren nach Anspruch 2 ist es denkbar, den Kabelbaum gleich im Werk des Zulieferers direkt am Bauteil herzustellen.

Die Montageunterlage kann aber auch eine Montageschablone, etwa in Form eines Tisches, einer Walze oder auch eines Produktionsbandes sein, wobei die Tischfläche, die Oberseite des Produktionsbandes bzw. die Umfangsfläche der Walze jeweils die Montageseite bilden. Bei einer solchen Verfahrensweise ist es zweckmäßig, wenn vor dem Aufbringen der Basisschicht eine Trennschicht auf die Montageunterlage, etwa durch Aufsprühen oder Aufstreichen, aufgebracht wird, die ein Loslösen des fertigen Kabelbaums von der Montageunterlage ermöglicht. Das jeweils verwendete Trennmittel hängt von der Materialpaarung Basisschicht-Montageunterlage ab und ist dementsprechend von Fall zu Fall unterschiedlich.

Bei einer besonders bevorzugten Ausführungsform werden auf der ersten Deckschicht weitere Adern verlegt und eine weitere Deckschicht aufgebracht. Diese Deckschicht kann dabei aus dem selben Material bestehen, wie die erste Deckschicht. Es kann aber auch ein davon unterschiedliches Material verwendet werden, etwa wenn die Deckschicht auch als mechanischer Schutz dienen und dementsprechend eine größere mechanische Widerstandsfähigkeit aufweisen soll. Auch ist es denkbar, daß das Material der letzten Deckschicht eine größere chemische Widerstandsfähigkeit gegenüber den Betriebsstoffen eines Kraftfahrzeuges aufweist, als etwa eine tieferliegende Deckschicht oder die Basisschicht. Das eben geschilderte Verfahren kann mehrfach wiederholt werden, so daß sich damit vielschichtige Kabelbäume aufbauen lassen.

Die Verlegung der Adern auf der Basisschicht bzw. auf dem Basisband einerseits und auf einer Deckschicht andererseits kann auf unterschiedliche Weise erfolgen. Im Falle von schnell aushärtenden Kunststoffen, ist es zweckmäßig, die Verlegung mit Hilfe eines Klebstoffes vorzunehmen. Dazu wird auf die entsprechende ausgehärtete bzw. verfestigte Schicht ein Klebstoff durch ein geeignetes Verfahren aufgetragen und auf diese Klebstoffschicht die Adern verlegt. Es können auch die Adern selbstklebend sein, indem beispielsweise die Adern vor dem Verlegen mit einem Klebstoff besprüht werden. Eine Fixierung der Adern an einer Basis- oder Deckschicht kann auch bei entsprechender Kunststoffwahl durch Hochfrequenz- oder Ultraschall-Schweißen erfolgen. Bei thermoplastischen Kunststoffen bietet sich eine Erwärmung der jeweiligen Schicht an, wobei die Adern in das erwärmte Schichtmaterial zumindest teilweise eingedrückt und darin eingebettet werden.

Zum Anbringen der an einem Kabelbaum üblicherweise vorhandenen Verbindungselemente kann folgendermaßen vorgegangen werden: Vorzugsweise werden die elektrischen Verbindungselemente bereits vor dem Aufbringen der Basisschicht bzw. des Basisbandes auf der Montageunterlage bleibend oder lösbar fixiert. Die elektrischen Verbindungselemente sind dabei so vorbereitet, daß ihre elektrischen Kontaktelemente, die vorzugsweise als Schneid-Klemm-Kontakte ausgebildet sind frei zugänglich sind, um die elektrisch-mechanische Verbindung zwischen den Aderenden und ihnen herzustellen. Um die genannte Zugänglichkeit zu gewährleisten können beispielsweise Verbindungselemente mit einem zweischaligen Gehäuse verwendet werden. Die eine, die elektrischen Kontaktelemente tragende Gehäusehälfte wird auf der Montageunterlage in einer Ausnehmung oder einem Durchbruch fixiert. Eine andere Möglichkeit besteht darin, die genannten Gehäusehälften unter Anwendung von Unterdruck an der Montageunterlage zu fixieren. Nachdem die Basisschicht auf der Montageunterlage aufgebracht ist, werden die Adern der ersten Aderschicht verlegt, wobei die Aderenden vorzugsweise automatisch, also durch die verwendete Verlegevorrichtung selbst, mit ihren Kabelenden in die Schneid-Klemmkontakte der Verbindungselemente eingedrückt werden. Vor dem Aufbringen der letzten Deckschicht werden die elektrischen Verbindungselemente durch Aufsetzen der zweiten Gehäusehälfte komplettiert. Um eine Abdichtung des Gehäuses zu erreichen kann es zweckmäßig sein, dieses zumindest im Bereich seiner Trennfuge mit Kunststoffmaterial, etwa beim Aufbringen einer abschließenden Deckschicht, zu umhüllen. Anschließend wird die letzte Deckschicht aufgebracht. Dabei kann, falls dies aus Gründen der Längs-Wasserdichtigkeit erforderlich ist, der Übergangsbereich zwischen elektrischem Verbindungselement und Kabelbaum mit dem Material der abschließenden Deckschicht umhüllt werden. Eine alternative Verfahrensweise besteht darin, auf die zweite Gehäusehälfte zu verzichten und eine hermetische Abdichtung der Verbindungselemente dadurch zu bewerkstelligen, daß beim Auftrag der abschließenden Deckschicht Deckschichtmaterial in das halbschalenartige Gehäuse des Verbindungselementes eingebracht wird.

Die Erfindung wird nun anhand von in den Zeichnungen dargestellten Ausführungsbeispielen näher erläutert. Es zeigen:
- Fig.1: eine schematische perspektivische Darstellung, die die Schrittabfolge eines erfindungsgemäßen Verfahrens wiedergibt,
- Fig.2: ein Fahrzeugbauteil mit einem erfindungsgemäß hergestellten Kabelbaum,
- Fig.3A-J: Schnittdarstellungen unterschiedlicher Bauvarianten erfindungsgemäß hergestellter Kabelbäume,
- Fig.4: den Ausschnitt eines Kabelbaums mit daran angeformtem Fixierelement,
- Fig.5: den Ausschnitt eines Flachkabelbaums mit integriertem elektronischen Bauteil in perspektivischer Darstellung und
- Fig.6: einen Kabelbaum in Querschnittsdarstellung, bei dem zwei Adern über eine Brücke miteinander verbunden sind.

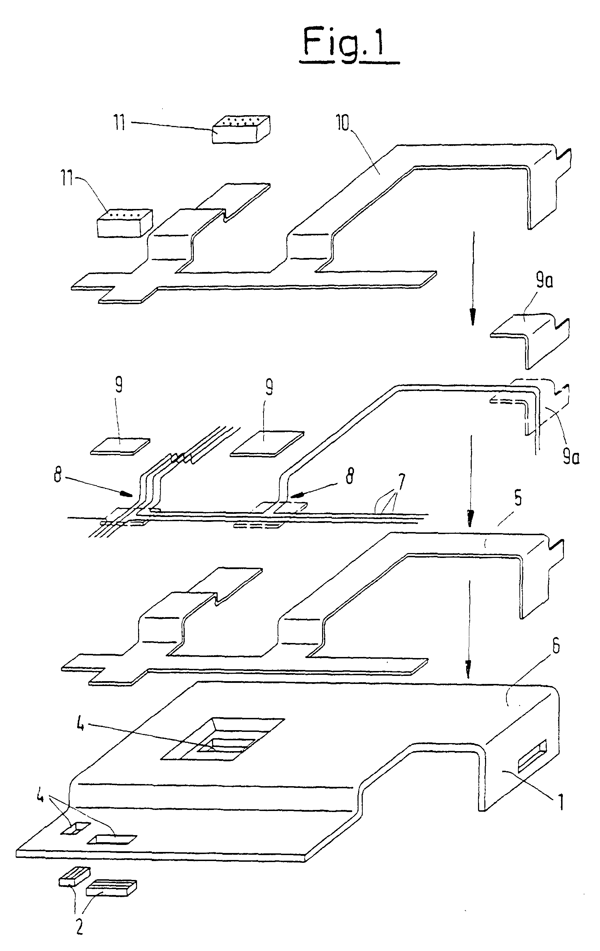

Anhand Fig. 1 wird eine bevorzugte Variante des erfindungsgemäßen Verfahrens beschrieben: Als Montageunterlage (1) dient ein Originalteil des Kraftfahrzeuges, beispielsweise ein Türrahmen. An diesem Türrahmen soll ein Kabelbaum direkt verlegt werden. Alternativ kann die Montageunterlage auch eine Montageschablone sein, die den dreidimensionalen Verlauf des Kabelbaumes am Originalbauteil naturgetreu wiedergibt. Im folgenden wird jedoch auf eine Montageunterlage Bezug genommen, die das Fahrzeugbauteil selbst ist.

An die Montageunterlage 1 werden zunächst von oben offene Gehäuseschalen 2 elektrischer Verbindungselemente 3 befestigt. Dazu sind an vorbestimmten Positionen Durchbrechungen 4 vorhanden, in die die Gehäuseschalen 2 eingesetzt werden. In den Gehäuseschalen 2 sind Schneid-Klemmkontakte vorhanden (nicht dargestellt). Als nächstes wird eine Basisschicht 5 auf die Montageseite 6 der Montageunterlage mit Hilfe einer automatisch gesteuerten Auftragevorrichtung (nicht dargestellt) aufgetragen. In Fig. 1 ist die Basisschicht 5 aus Übersichtlichkeitsgründen von der Montageunterlage 1 losgelöst gezeichnet. Als Material für die Basisschicht steht eine Vielzahl unterschiedlicher Materialien zur Verfügung. Die Materialauswahl richtet sich beispielsweise nach den gewünschten Hafteigenschaften im Hinblick auf das Material der Montageunterlage 1 oder danach, welcher Art die spätere Verbindung zwischen den Einzeladern des Kabelbaums und der Basisschicht 5 sein soll. Das Material der Basisschicht kann das oben erwähnte Polyurea-Sprühelastomer, ein Kleber, beispielsweise ein Thermokleber, ein thermoplastischer Kunststoff, ein vernetzbarer Kunststoff, ein lichtaushärtender Kunststoff, ein sinterbarer Kunststoff oder dergleichen sein. Als Material für die Basisschicht 5 wird vorzugsweise ein von der Firma Plasto, F-21304 Chenove Cedex, Frankreich, unter der Bezeichnung "KI 28" vertriebener Klebstoff verwendet, der eine. Mischung aus thermoschmelzbaren Polymeren und Additiven ist. Dieser Stoff weist nach dem Auftragen eine dauerhafte Klebrigkeit auf, so daß die den Kabelbaum bildenden Adern 7 fest an einer aus diesem Material bestehenden Basisschicht 5 haften: Die Adern 7 können entweder isoliert oder unisoliert sein. Die Einzeladern können beispielsweie nur einem Hauptast folgen, sie können aber davon nach Art eines Seitenastes abzweigen. Im Falle von Verzweigungsstellen bei unisolierten Adern ist es erforderlich, daß zumindest die Verzweigungsstelle 8 mit einer Isolierschicht 9 überdeckt wird, bevor weitere, die Verzweigungstelle überquerende Adern verlegt werden. Mechanisch besonders beanspruchte Stellen des Kabelbaumes sind durch zusätzliche Deckschichtabschnitte 9a verstärkt.

Als nächster Arbeitsgang wird auf die Adern 7 eine Deckschicht 10 ebenfalls mit Hilfe einer automatisch gesteuerten Auftragevorrichtung (nicht dargestellt) aufgebracht. Das Material der Deckschicht ist so gewählt, daß es sich mit dem Material der Basisschicht 5 verbindet. Vorzugsweise wird ein Material verwendet, das zusätzlich an den Adern 7 bzw. an deren Isolierung haftet. Als nächstes werden die Gehäuseschalen 2 der elektrischen Verbindungselemente mit Gehäusedeckeln 11 komplettiert. Die Schichtdicke der Basisschicht 5 sowie der Deckschicht 10 kann je nach Anforderung mehr oder weniger stark gewählt sein. Auch ist es denkbar, daß die genannten Schichten eine schaumartige Konsistenz aufweisen, um damit Gewicht einzusparen oder die mechanischen Eigenschaften des Kabels zu beeinflussen.

Als Material für die abschließende Deckschicht wird vorzugsweise ein schnell aushärtendes Material gewählt, etwa das oben erwähnte Polyurea-Sprühelastomer. Ein solches Material schließt den Kabelbaum nach außen ab und bildet eine im wesentlichen glatte Oberfläche, die gegebenenfalls bedruckt oder mit Kennzeichnungen versehen werden kann.

Wenn die vorgegebene Breite einer Basisschicht nicht ausreicht, um sämtliche erforderlichen Adern des Kabelbaums aufzunehmen, kann ein erfindungsgemäßer Kabelbaum mehrschichtig aufgebaut sein. Dabei werden auf eine Deckschicht weitere Adern verlegt, auf die jeweils eine Deckschicht aufgebracht wird. Dabei wird etwa so vorgegangen, daß vor Verlegen neuer Adern abgewartet wird, bis die Deckschicht, auf die Adern verlegt werden sollen, zumindest teilweise ausgehärtet ist bzw. sie sich teilweise verfestigt hat. Auf die ausgehärtete Deckschicht wird dann eine weitere Aderschicht auf die oben beschriebene Art und Weise verlegt.

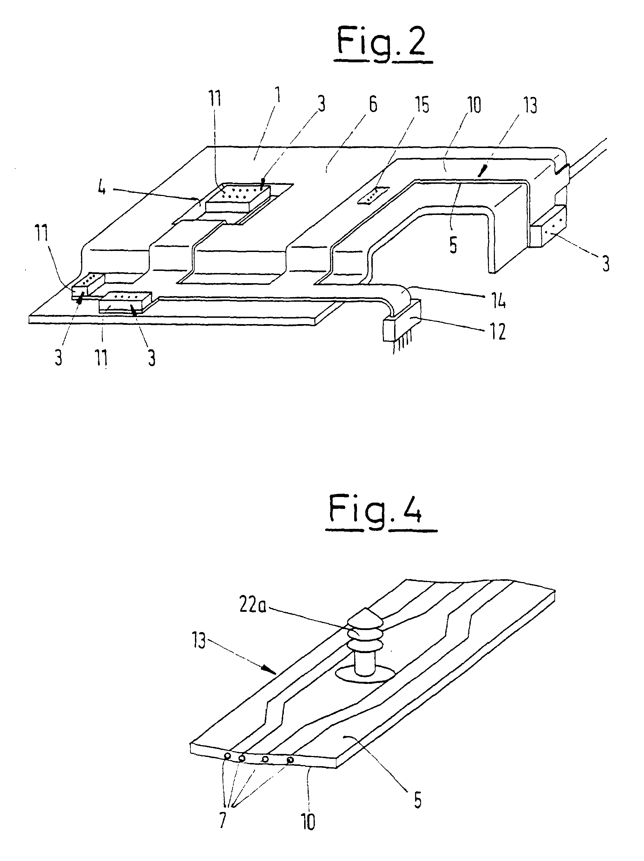

Fig. 2 zeigt die mit einem Kabelbaum komplettierte Montageunterlage 1. Es ist erkennbar, daß neben den Verbindungselementen 3, die sich aus zwei Gehäusehälften zusammensetzen, auch solche Verbindungselemente 12 am Kabelbaum 13 vorhanden sein können, die an einem nicht von der Montageunterlage 1 unterstützten Seitenast 14 des Kabelbaums 13 angeordnet sind. Ein solches Verbindungselement 12 wird zweckmäßigerweise nach Fertigstellung des Kabelbaums montiert. Weiterhin ist erkennbar, daß in einen erfindungsgemäßen Kabelbaum Einbauten integriert sein können, beispielsweise ein Diagnoseanschluß 15 oder ein elektronisches Bauteil.

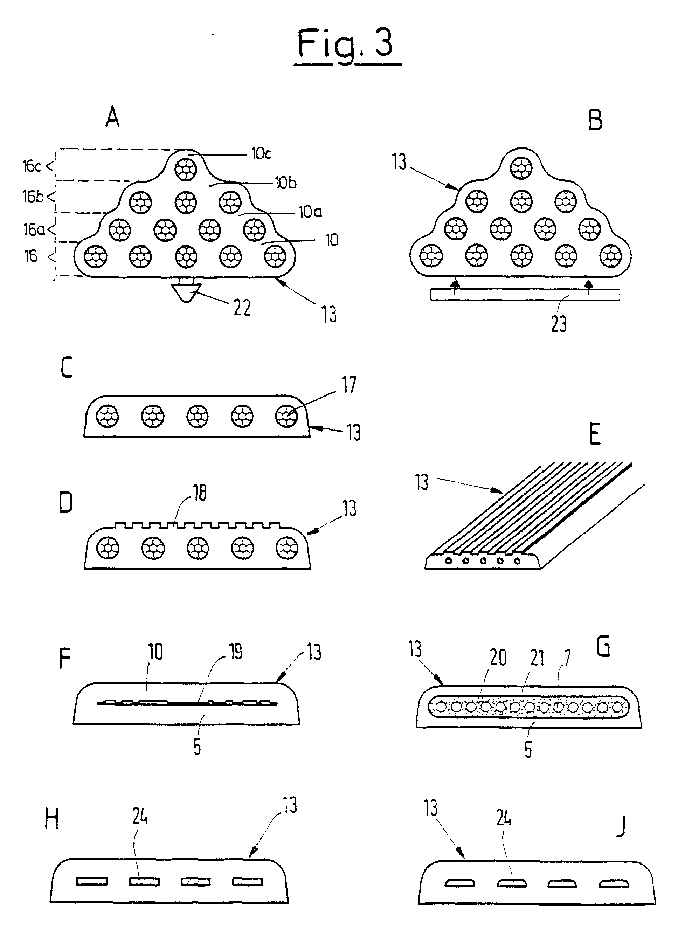

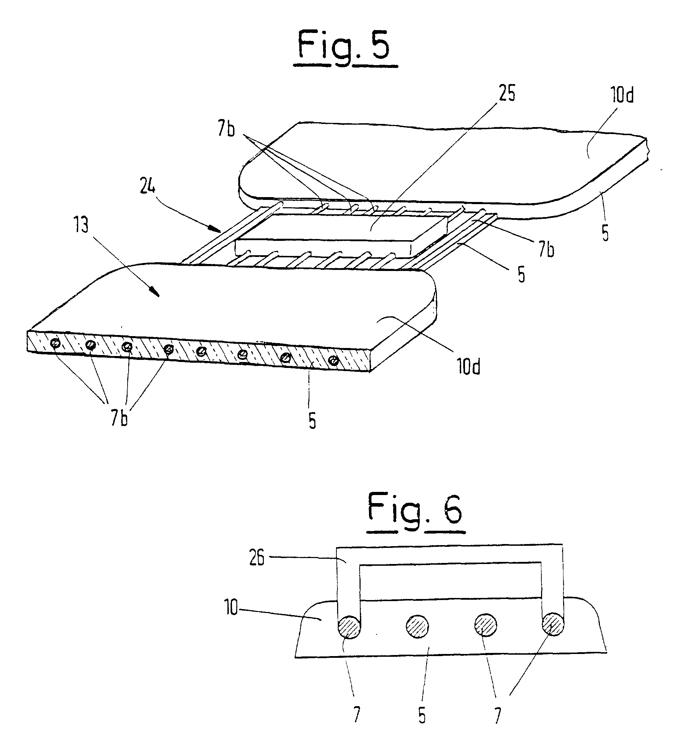

In Fig.3A-G sind unterschiedliche Querschnittsformen eines erfindungsgemäßen Kabelbaums dargestellt. In den Zeichnungen sind aus Vereinfachungsgründen Adern mit gleichen Querschnitten dargestellt. Es können aber innerhalb eines Kabelbaums Adern unterschiedlicher Stärke und Querschnittsform vorhanden sein. Fig.3A und 3B zeigen einen mehrschichtigen Kabelbaum, der im Querschnitt etwa eine dreieckige Form aufweist. Diese Dreiecksform ergibt sich daraus, daß aufeinanderfolgende, jeweils eine Aderschicht und eine Deckschicht umfassende, Teilschichten 16,16a,16b,16c in ihrer Breite abnehmen. Dies ist ein Erfordernis, das sich ergibt, wenn die Deckschichten durch Auftrag eines zunächst mehr oder weniger flüssigen Materials erzeugt werden. An der Unterseite des Kabelbaums nach Fig.3A ist ein pilzförmiges Fixierelement 22 angeformt. Ein ähnliches Fixierelement 22a ist auch bei dem Kabelbaumausschnitt gemäß Fig.4 vorhanden. Ein solches Fixierelement 22,22a kann dadurch erzeugt werden, daß in der Montageunterlage eine dem pilzförmigen Fixierelement entsprechende Formaushöhlung vorhanden ist, in die das Material der Basisschicht bei deren Auftrag eindringt. Ein andere Möglichkeit besteht darin, ein vorgefertigtes Fixierelement so in einer Aufnahmeöffnung der Montageunterlage anzuordnen, daß es mit einem Fixierende aus der Montageunterlage herausragt und beim Auftragen der Basisschicht an diese angeformt wird. Die Fixierung eines auf die oben beschriebene Art und Weise hergestellten Kabelbaumes an einem Fahrzeugbauteil kann auch dadurch erfolgen, daß an die Außenseite, vorzugsweise im Bereich der Basisschicht, eine doppelseitige Klebefolie 23 fixiert wird, wie dies in Fig.3B dargestellt ist, Fig.3C zeigt einen einschichtigen Flachkabelbaum mit insgesamt fünf Adern bzw. Leitungen 17. Die Oberfläche des in Fig.3D und 3E dargestellten Kabelbaums weist in Längsrichtung und parallel zueinander laufende Rippen 18 auf. die beispielsweise zur Versteifung des Kabelbaums und als Verschleißschutz dienen können. Bei dem Kabelbaum nach Fig.3F wurde anstelle von mehreren Einzeladern ein Folienleitungssatz 19 auf die Basisschicht 5 verlegt. Bei dem Kabelbaum nach Fig.3G sind die Adern 7 in einem Kern 20 aus geschäumtem Material eingebettet. Der Schaumkern kann etwa dadurch erzeugt werden, daß auf die Basisschicht 5 zunächst eine Deckschicht aus Schaummaterial aufgebracht und auf diese Schaumschicht wiederum die Adern 7 verlegt werden. Gegebenenfalls kann eine weitere, die Adern 7 abdeckende Schaumschicht aufgetragen werden. Nach Aushärten der Schaumschicht wird schließlich eine den Kern 20 umhüllende Abschlußschicht 21 aufgetragen. Bei den in Fig.3H und 3l dargestellten Kabelbäumen wurden Metallfolien 24 als Adern bzw. Leitern verwendet. Im Falle der Abbildung 3H sind die Metallfolien im Querschnitt quaderförmig. Bei dem Kabelbaum nach Fig.3J weisen die Metallfolien ebenfalls ein im wesentlichen rechteckiges Querschnittsprofil auf, allerdings sind die Ränder etwas abgerundet.

Oftmals ist es erforderlich, ein elektrisches oder elektronisches Bauteil in den Kabelbaum zu integrieren, wie dies etwa in Fig.5 dargestellt ist. Hier ist in einer Deckschicht 10d eine Lücke bzw. ein Isolationsfenster 24 vorhanden, das die davor und danach von der Deckschicht 10d überdeckten Adern 7b freiläßt. Die Adern 7b können im Bereich des Isolationsfensters 24 aufgetrennt und beispielsweise ein elektronisches Bauteil 25 zwischengeschaltet werden. Das Isolationsfenster wird nach Einfügen des Bauteils 25 mit einem Deckschichtabschnitt (nicht dargestellt) überdeckt bzw. abgedichtet. Dies kann auch im Zuge des Schichtaufbaus eines mehrschichtigen Kabelbaumes erfolgen. Zur Anpassung an ein relativ kleines Bauteil mit engem Anschluß-Rastermaß kann es zweckmäßig sein, die Adern im Bereich des Isolationsfensters 24 mit geringerem Abstand zueinander zu verlegen. Die Basisschicht 5 und dementsprechend sich darüber befindliche Deckschichten können im Bereich des Isolationsfensters 24 seitlich eingezogen sein, also eine geringere Breite aufweisen als der übrige Kabelbaum. Neben den erwähnten elektronischen Bauteilen sind auf die geschilderte Art und Weise auch Brücken 26 zwischen den Adern 7 eines Kabelbaumes herstellbar, wie dies etwa in Fig.6 dargestellt ist.

### Bezugszeichenliste

- 1.: Montageunterlage
- 2.: Gehäuseschale
- 3.: Verbindungselement
- 4.: Durchbrechung
- 5.: Basisschicht
- 6.: Montageseite
- 7.: Ader
- 8.: Verzweigungsstelle
- 9.: Isolierschicht
- 9a: Deckschichtabschnitt
- 10.: Deckschicht
- 11.: Gehäusedecke
- 12.: elektrisches Verbindungselement
- 13.: Kabelbaum
- 14.: Seitenast
- 15.: Diagnoseanschluß
- 16.: Teilschicht
- 17.: Leitung
- 18.: Rippe
- 19.: Folienleitungssatz
- 20.: Kern
- 21.: Abschlußschicht
- 22.: Fixierelement
- 23.: Klebefolie
- 24.: Isolationsfenster
- 25.: Elektronisches Bauteil
- 26.: Brücke

## Patentansprüche

1. Verfahren zur Herstellung eines Kabelbaums, insbesondere für Kraftfahrzeuge mit folgenden Verfahrensschritten:
a) auf die Montageseite einer Montageunterlage (1) wird eine im wesentlichen streifenförmige, dem räumlichen Verlauf (6) des herzustellenden Kabelbaums zumindest abschnittsweise folgende Basisschicht (5) aufgebracht, die zumindest vorübergehend an der Montageseite haftet,
b) an der Basisschicht (5) werden mehrere im wesentlichen parallel nebeneinander angeordnete Adern (7) fixiert,
c) auf die Basisschicht wird eine Deckschicht (10) aus einem flüssigen oder geschmolzenen Kunststoffmaterial aufgesprüht, aufextrudiert, aufgegossen oder aufgestrichen oder es wird ein granuliertes oder pulverförmiges Kunststoffmaterial aufgebracht und anschließend nach Art eines Sinterprozesses mit Wärme, Ultraschall oder dergleichen behandelt, wobei das Kunststoffmaterial die Adern (7) einhüllt, an der Basisschicht haftet und nach dem Aufbringen und gegebenenfalls nach der Sinterbehandlung aushärtet bzw. allgemein in eine festere Konsistenz übergeht,
**dadurch gekennzeichnet,**
**daß** die Basisschicht (5) thixotrop eingestellt wird und erzeugt wird, indem ein flüssiges oder geschmolzenes Kunststoffmaterial auf die Montageunterlage aufgesprüht aufextrudiert aufgegossen oder aufgestrichen wird oder indem ein granuliertes oder pulverförmiges Kunststoffmaterial aufgebracht und anschließend nach Art eines Sinterprozesses mit Wärme, Ultraschall oder dergleichen behandelt wird, wobei das Kunststoffmaterial nach dem Aufbringen und gegebenenfalls nach Sinterbehandlung aushärtet bzw. allgemein in eine festere Konsistenz übergeht.

2. Verfahren nach Anspruch 1,
**dadurch gekennzeichnet,**
**daß** die Montageunterlage (1) selbst das Fahrzeugbauteil, beispielsweise eine Fahrzeugtüre ist, und daß die Basisschicht (5) bleibend daran fixiert wird

3. Verfahren nach Anspruch 1,
**dadurch gekennzeichnet,**
**daß** als Montageunterlage (1) eine Montageschablone in Form eines Tisches, einer Walze oder eines Produktionsbandes verwendet wird, wobei die Tischfläche, die Oberseite des Projektionsbandes bzw. die Umfangsfläche der Walze jeweils die Montageseite bilden.

4. Verfahren nach Anspruch 3.
**dadurch gekennzeichnet,**
**daß** zwischen der Montageunterlage (1) und der Basisschicht (5) eine Trennschicht angeordnet, beispielsweise auf die Montageseite (6) aufgesprüht oder aufgestrichen wird.

5. Verfahren nach einem der vorhergehenden Ansprüche,
**dadurch gekennzeichnet,**
**daß** das Kunststoffmaterial ein schnellhärtender Kunststoff, beispielsweise ein Polyurea-Sprühelastomer ist.

6. Verfahren nach einem der Ansprüche 1 bis 4,
**dadurch gekennzeichnet,**
**daß** zur Herstellung zur Basisschicht (5) eine Kunststoffschmelze oder die Ausgangsmischung eines Zweikomponenten-Kunststoffes, beispielsweise Polyurethan. auf die Montageunterlage aufgebracht wird.

7. Verfahren nach Anspruch 6,
**dadurch gekennzeichnet,**
**daß** die Kunststoffschmelze oder die Ausgangsmischung thixotrop eingestellt sind.

8. Verfahren nach einem der Ansprüche 1 - 7,
**dadurch gekennzeichnet,**
**daß** auf der Deckschicht (10) weitere Adern verlegt werden, auf die eine weitere Deckschicht (10a) aufgebracht wird.

9. Verfahren nach Anspruch 8,
**dadurch gekennzeichnet,**
**daß** zur Bildung eines vielschichtigen Kabelbaums weitere Adern (7) und weitere Deckschichten (10b,10c) aufgebracht werden.

10. Verfahren nach einem der Ansprüche 1 - 9,
**dadurch gekennzeichnet,**
**daß** die Adern auf der Basisschicht (5) bzw. auf einer Deckschicht (10,10a,10b) mit Hilfe eines Klebstoffs verlegt werden.

11. Verfahren nach einem der Ansprüche 1 - 10,
**dadurch gekennzeichnet,**
**daß** als Material für die Basisschicht (5) oder für die Deckschicht (10, 10a, 10b) ein thermoplastisches Kunststoffmaterial verwendet wird, daß dieses Material unter Anwendung von Wärme erweicht und die zu verlegenden Adern (7) in das erweichte Material zumindest teilweise eingedrückt werden.

12. Verfahren nach einem der Ansprüche 1 - 11,
**dadurch gekennzeichnet,**
**daß** die Verlegung der Adern (7) kurz nach dem Aufsprühen, Aufextrudieren oder Aufgießen eines Kunststoffmaterials zur Bildung einer Basisschicht (5) oder einer Deckschicht (10,10a,10b), also zu einem Zeitpunkt erfolgt, zu dem das Kunststoffmaterial noch nicht erhärtet ist.

13. Verfahren nach einem der Ansprüche 1 - 12,
**dadurch gekennzeichnet,**
**daß** vor dem Aufbringen der Basisschicht (5) auf der Montageunterlage (1) auf dieser elektrische Verbindungselemente (12) bleibend oder lösbar fixiert werden, wobei die vorzugsweise als Schneid-Klemm-Kontakte ausgebildeten elektrischen Kontaktelemente zur elektrisch-mechanischen Verbindung mit den Aderenden frei zugänglich sind.

14. Verfahren nach Anspruch 13,
**dadurch gekennzeichnet,**
**daß** die elektrischen Verbindungselemente (12) nach dem Aufbringen einer letzten, als Abschlußschicht dienenden Deckschicht (10) auf den Kabelbaum mit einem Gehäusedeckel (11) abgeschlossen werden.

15. Verfahren nach Anspruch 14,
**dadurch gekennzeichnet,**
**daß** beim Aufbringen der letzten Deckschicht auf den Kabelbaum die elektrischen Verbindungselemente zumindest teilweise mit dem die Deckschicht bildenden Kunststoffmaterial ausgefüllt bzw. umgossen oder umsprüht werden.

16. Verfahren nach einem der Ansprüche 1 - 15,
**dadurch gekennzeichnet**.
daß die Deckschicht derart auf die Basisschicht (5) oder eine bereits darauf vorhandene Deckschicht aufgebracht wird, daß ein deckschichtfreies Isolationsfenster (24) gebildet wird, in dem die Adern (7a) zum Anschluß eines elektronischen Bauteils (25), einer Brücke (26) oder dergleichen frei zugänglich sind.

## Claims

1. Method for producing a cable harness, in particular for motor vehicles, having the following method steps:
a) a base layer (5) which is essentially in the form of strips, follows the three-dimensional profile (6) of the cable harness to be produced, at least in sections, and adheres at least temporarily on the mounting side, is fitted to the mounting side on a mounting base (1).
b) a number of conductors (7) which are arranged essentially parallel alongside one another, are fixed on the base layer (5),
c) a covering layer (10) composed of a liquid or molten plastic material is sprayed, extruded, poured or painted on to the base layer, or a granulated or powdery plastic material is applied to the base layer, and is then treated with heat, ultrasound or the like in the form of a sintering process, with the plastic material encasing the conductors (7) adhering to the base layer and, after application, and if appropriate after the sintering treatment, curing or in general changing to a more solid consistency,
**characterized**
**in that** the base layer (5) is produced by a liquid or molten plastic material being sprayed or extruded onto the mounting base or by a granulated or powdery plastic material being applied to the mounting base and then being treated with heat, ultrasound or the like in the form of a sintering process, with the plastic material curing after the application, and, if appropriate, after the sintering treatment, or in general changing to a more solid consistency.

2. Method according to Claim 1,
**characterized**
**in that** the mounting base (1) is itself the vehicle component, for example a vehicle door, and in that the base layer (5) is permanently fixed to it.

3. Method according to Claim 1,
**characterized**
**in that** a mounting template in the form of a table, a roller or a production belt is used as the mounting base (1), with the table surface, the upper face of the projection belt, or the circumference surface of the roller in each case forming the mounting face.

4. Method according to Claim 3,
**characterized**
**in that** a separating layer is arranged between the mounting base (1) and the base layer (5), for example being sprayed or painted on to the mounting face (6).

5. Method according to one of the preceding claims,
**characterized**
**in that** the plastic material is a fast-curing plastic, for example a polyurea spraying elastomer.

6. Method according to one of Claims 1 to 4,
**characterized**
**in that**, for production to form the base layer (5), a plastic melt, or an original mixture of a two-component plastic, for example polyurethane, is applied to the mounting base.

7. Method according to Claim 6,
**characterized**
**in that** the plastic melt or the original mixture is set to the thixotropic.

8. Method according to one of Claims 1 - 7,
**characterized**
**in that** further conductors are laid on the covering layer (10) and a further covering layer (10a) is applied to these conductors.

9. Method according to Claim 8,
**characterized**
**in that** further conductors (7) and further covering layers (10b, 10c) are applied in order to form a multi-layer cable harness.

10. Method according to one of Claims 1 - 9,
**characterized**
**in that** the conductors are laid on the base layer (5) or on a covering layer (10, 10a, 10b) with the aid of an adhesive.

11. Method according to one of Claims 1 - 10,
**characterized**
**in that** a thermoplastic material is used as the material for the base layer (5) or for the covering layer (10, 10a, 10b), and in that this material softens when heat is applied and the conductors (7) to be laid are at least partially pressed into the softened material.

12. Method according to one of Claims 1 - 11,
**characterized**
**in that** the conductors (7) are laid shortly after the spraying or extrusion of the plastic material in order to form a base layer (5) or a covering layer (10, 10a, 10b), that is to say at a time at which the plastic material has not yet cured.

13. Method according to one of Claims 1 - 12,
**characterized**
**in that** electrical connecting elements (12) are permanently or detachably fixed to the mounting base (1) before the base layer (5) is applied to the mounting base (1), with the electrical contact elements, which are preferably in the form of insulation-displacement terminal contacts, being freely accessible to form an electrical/mechanical connection to the conductor ends.

14. Method according to Claim 13,
**characterized**
**in that** the electrical connecting elements (12) are sealed by means of a housing cover (11) after the application of a final covering layer (10), which is used as a sealing layer, to the cable harness.

15. Method according to Claim 14,
**characterized**
**in that**, during the application of the final covering layer to the cable harness, the electrical connecting elements are at least partially filled, extrusion coated or completely sprayed with the plastic material forming the covering layer.

16. Method according to one of Claims 1 - 15,
**characterized**
**in that** the covering layer is applied to the base layer (5) or to a covering layer which is already present thereon, in such a manner that an insulation window (24), which is free of the covering layer is formed, in which the conductors (7a) are freely accessible for connection of an electronic component (25), a link (26) or the like.

## Revendications

1. Procédé pour la réalisation d'un harnais de câbles, particulier pour véhicule automobile, comprenant les opérations suivantes:
a) sur le côté montage d'un support de montage (1) on appose une couche de base (5) sensiblement en forme de ruban, qui suit au moins par tronçons le tracé dans l'espace (6) du harnais de câbles à réaliser, et qui adhère au moins provisoirement sur le côté montage,
b) sur la couche de base (5) ont fixe plusieurs brins de câbles (7) agencés sensiblement parallèlement les uns à côté des autres,
c) une couche de couverture (10) en matière plastique liquide ou fondue est appliquée sur la couche de base par pulvérisation, par coextrusion, par coulée, ou par application au pinceau, ou on applique une matière plastique sous forme de granulés ou de poudre et on la traite ensuite, selon le mode d'un processus de frittage, à l'aide de chaleur, d'ultrasons ou similaire, de sorte que la matière plastique enrobe les brins de câbles (7), adhère sur la couche de base, et durcit ou passe de façon générale à une consistance solide après son application et le cas échéant après le traitement de frittage,
**caractérisé en ce que** la couche de base (5) est établie de façon thixotrope et produite en appliquant une matière plastique liquide ou fondue sur le support du montage par pulvérisation, par coextrusion, par coulée ou par application au pinceau, ou en appliquant une matière plastique sous forme de granulés ou de poudre et en la traitant ensuite selon le mode d'un processus de frittage à l'aide de chaleur, d'ultrasons ou similaire, de sorte que la matière plastique durcit, ou passe de façon générale à une consistance solidaire après son application et le cas échéant après le traitement de frittage.

2. Procédé selon la revendication 1, **caractérisé en ce que** le support de montage (1) est lui-même un composant du véhicule, par exemple une porte de véhicule, et en ce que la couche de base (5) est fixée à demeure sur celui-ci.

3. Procédé selon la revendication 1, **caractérisé en ce que** l'on utilise comme support de montage (1) un gabarit de montage sous la forme d'une table, d'un cylindre, ou d'une bande de production, et en ce que la surface de la table, la face supérieure de la bande de production, ou la surface périphérique du cylindre constitue respectivement le côté montage.

4. Procédé selon la revendication 3, **caractérisée en ce que** l'on dispose entre le support de montage (1) et la couche de base (5) une couche de séparation, par exemple pulvérisée ou appliquée au pinceau sur le côté de montage (6).

5. Procédé selon l'une des revendications précédentes, **caractérisée en ce que** la matière plastique est une matière plastique à durcissement rapide, par exemple un élastomère à pulvériser du type polyurée.

6. Procédé selon l'une des revendications 1 à 4, **caractérisé en ce que** pour réaliser la couche de base (5) on applique sur le support de montage une matière plastique en fusion, ou le mélange de départ d'une matière plastique à deux composantes, par exemple du polyuréthane.

7. Procédé selon la revendication 6, **caractérisé en ce que** la matière plastique en fusion ou le mélange de départ sont établis de manière thixotrope.

8. Procédé selon l'une des revendications 1 à 7, **caractérisé en ce que** l'on pose d'autres brins de câbles sur la couche de couverture (10), sur lesquels on applique une autre couche de couverture (10a).

9. Procédé selon la revendication 8, **caractérisé en ce que** pour constituer un harnais de câbles à plusieurs couches, on applique d'autres brins de câbles (7) et d'autres couches de couverture (10b, 10c).

10. Procédé selon l'une des revendications 1 à 9, **caractérisé en ce que** les brins de câble sont posés sur la couche de base (5), ou sur une couche de couverture (10, 10a, 10b) à l'aide d'une colle.

11. Procédé selon Tune des revendications 1 à 10, **caractérisé en ce que** l'on utilise comme matériau pour la couche de base (5) ou pour la couche de couverture (10, 10a, 10b) une matière thermoplastique, en ce que ce matériau est ramolli par application de chaleur, et en ce que les brins de câbles à poser (7) sont au moins partiellement enfoncés dans le matériau ramolli.

12. Procédé selon l'une des revendications 1 à 11, **caractérisé en ce que** la pose des brins de câbles (7) a lieu brièvement après la pulvérisation, la coextrusion, ou la coulée de la matière plastique pour former une couche de base (5) ou une couche de couverture (10, 10a, 10b), donc à un instant auquel la matière plastique n'est pas encore durcie.

13. Procédé selon l'une des revendications 1 à 12, **caractérisé en ce qu'**avant d'appliquer la couche de base (5) sur le support de montage (1) on fixe à demeure ou de façon détachable de sur celui-ci des éléments de connexion électrique (12), et ce que les éléments de contact électrique réalisés de préférence sous la forme de contacts à serrage et à couteaux sont librement accessibles en vue de la liaison électrique/mécanique avec les extrémités des brins.

14. Procédé selon la revendication 13, **caractérisé en ce que** les éléments de connexion électrique (12) sont enfermés sur le harnais de câble au moyen d'un couvercle de boîtier (1) après application d'une dernière couche de couverture (10) servant de couche terminale.

15. Procédé selon la revendication 14, **caractérisé en ce que** lorsqu'on applique la dernière couche de couverture sur le harnais de câbles, les éléments de connexion électrique sont au moins partiellement remplis, ou enrobés par coulée ou pulvérisation, avec la matière plastique qui constitue la couche de couverture.

16. Procédé selon l'une des revendications 1 à 15, **caractérisé en ce que** la couche de couverture est appliquée sur la couche de base (5) ou sur une couche de couverture existant déjà sur celle-ci, de telle manière que l'on forme une fenêtre d'isolation dépourvue de couche de couverture dans laquelle les brins de câbles (7a) sont librement accessibles en vue du raccordement d'un composant électronique (25), d'un pont (26) ou similaire.
